# EUROPÄISCHE PATENTSCHRIFT

(11) **EP 1 075 030 B1**
(45) Veröffentlichungstag und Bekanntmachung des Hinweises auf die Patenterteilung: **06.04.2005**
(21) Anmeldenummer: 00115501.9
(22) Anmeldetag: 18.07.2000
(51) Int. Cl.: H01L 39/14, H01L 39/24, H01B 13/16, H01B 12/00, C08J 3/28

(54) **Isolierter bandförmiger Supraleiter mit oxidischem Hoch-Tc-Supraleitermaterial sowie Verfahren zur Isolation des Supraleiters**
Insulated tape superconductor comprising oxide high-Tc-superconductor materials and method for insulating the superconductor
Supraconducteur isolé en forme de bande composé du supraconducteur d'oxyde à haute température et procédé pour isoler le supraconducteur

(30) Priorität: 04.08.1999 DE 19936680
(43) Veröffentlichungstag der Anmeldung: 07.02.2001
(73) Patentinhaber: SIEMENS AKTIENGESELLSCHAFT, 80333 München (DE)
(72) Erfinder: Albrecht, Cord, Dipl.-Ing., 91058 Erlangen (DE); Kummeth, Peter, Dr., 91074 Herzogenaurach (DE); Massek, Peter, 91301 Forchheim (DE); Schön, Lothar, Dipl.-Ing. (FH), 91077 Neunkirchen (DE)

(56) Entgegenhaltungen:
- EP-A- 0 126 712
- EP-A- 0 490 854
- DE-A- 19 755 445
- DE-C- 19 620 824
- GB-A- 943 151
- US-A- 4 039 415
- YONG LIE CHEN ET AL: "PHOTOCROSSLINKING OF ULTRA HIGH STRENGTH POLYETHYLENE FIBERS" POLYMERS FOR ADVANCED TECHNOLOGIES, JOHN WILEY AND SONS, CHICHESTER, GB, Bd. 1, Nr. 1, 1. Februar 1990 (1990-02-01), Seiten 103-107, XP000316142 ISSN: 1042-7147

## Beschreibung

Die Erfindung bezieht sich auf einen bandförmigen Supraleiter mit einem Leiteraufbau, der mindestens einen in normalleitendes Material eingebetteten Leiterkern aus einem oxidischen Hoch-T_{c}-Supraleitermaterial enthält und ein großes Aspektverhältnis aufweist, sowie mit einer Isolation aus einem UV-vernetzten Kunststofflack mit einer Schichtdicke von unter 50 µm. Die Erfindung betrifft ferner ein Verfahren zur Isolation eines solches Supraleiters. Ein entsprechender Supraleiter geht aus der DE 197 55 445 A1 hervor.

Technische Supraleiter müssen für eine Verwendbarkeit in elektrischen Einrichtungen wie Wicklungen von Maschinen, Transformatoren, Magneten oder Kabeln im allgemeinen mit einer elektrischen Isolation versehen werden. Ein solches Erfordernis ist insbesondere auch bei Leitern mit oxidischem Hoch-T_{c}-Supraleitermaterial (HTS-Material) gegeben. Dabei sollen solche HTS-Leiter, die eine Drahtform (mit kreisförmigem Querschnitt) und insbesondere eine Bandform (mit rechteckigem Querschnitt) haben können, in einem einfach durchzuführenden Verfahren kontinuierlich mit einer isolierenden Umhüllung versehen werden können. Von einem solchen Verfahren wird außerdem gefordert, daß es sowohl für eine Einleiterisolation wie auch zur Isolation eines HTS-Leiteraufbaus in Form eines Mehrfachleiters, der aus supraleitenden Einzelleitern zusammengesetzt ist, oder eines Verbundleiters mit supraleitenden und normalleitenden Teilen geeignet ist.

Bisher sind keine in technischem Maßstab realisierbaren Verfahren bekannt geworden, mit denen in einem kontinuierlichen Durchlauf ein Supraleiter oder -leiteraufbau insbesondere unter Verwendung von HTS-Material allseitig mit einer isolierenden Umhüllung zu versehen ist. Dies ist unter anderem darauf zurückzuführen, daß die zur Zeit verfolgten HTS-Leiterkonzepte eine Bandform vorsehen, die ein im Hinblick auf die in der Supraleitungstechnik praktizierten Isolationsverfahren ungünstig hohes Aspektverhältnis (= Verhältnis von Leiterbreite zu Leiterdicke) aufweisen. Solche Leiter sind nämlich mit den bekannten Verfahren nur schwer gleichmäßig und schwer mit einem Isolationsmaterial geringer Dicke zu beschichten. Bei einem aus der EP 0 292 126 B1 zu entnehmenden HTS-Leiter ist deshalb die Umhüllung verhältnismäßig dick ausgeführt.

Um eine Anwendung bekannter bandförmiger HTS-Leiter z.B. im Magnetwicklungsbau zu ermöglichen, wurden bisher separate Isolationsfolien z.B. aus einem speziellen aromatischen Polyamid, das unter dem Handelsnamen Kapton" bekannt ist und eine Dicke von beispielsweise 50 µm hat, zusammen mit dem Bandleiter gewickelt. Somit muß zur Herstellung von Wicklungen neben einer Abwickelvorrichtung für den Leiter zusätzlich eine entsprechende Vorrichtung für die Isolationsfolie vorgesehen werden, um eine Isolation zwischen den einzelnen Lagen bzw. Windungen einer Wicklung zu erstellen. Dabei kann die Schwierigkeit auftreten, daß der Leiter nicht ganz durch die Isolationsfolie umhüllt wird. Außerdem ist jeweils nur eine Trennschicht zwischen den einzelnen Leiterlagen vorhanden, wobei die seitlichen Leiterkanten unisoliert bleiben. Um eine sichere Isolation auch in diesen Bereichen zu gewährleisten, ist entweder ein Verguß des Wickelpaketes mit Gießharz oder die Verwendung von so breiten Isolationsfolien erforderlich, daß durch einen seitlichen Überstand der Folie über die jeweiligen Leiterkanten hinaus ein Kurzschluß zwischen den Leitern verhindert wird. Der Justieraufwand, um ein paralleles Wickeln von Leiter und Isolationsfolie zu ermöglichen, ist jedoch verhältnismäßig aufwendig.

Darüber hinaus ist aus der Isolationstechnik von Supraleitern mit sogenanntem klassischen Supraleitermaterial, das eine LHe-Kühltechnik erforderlich macht, bekannt, einen z.B. bandförmigen Supraleiter mit einer entsprechenden Kunstsfoffolie zu umwickeln (vgl. die DE 23 45 779 A oder die DE 38 23 938 C2). Auch diese Verfahren sind nur mit verhältnismäßig hohem Aufwand durchführbar. Außerdem müssen die verwendeten Folien eine hinreichende Dicke haben, um mechanische Beschädigungen bei dem Umwicklungsprozeß auszuscheiden.

Aus der eingangs genannten DE 197 55 445 A1 ist ein isolierter Supraleiter mit Bandform zu entnehmen, der einen Leiteraufbau unter Verwendung von oxidischem Hoch-T_{c}-Supraleitermaterial aufweist. Der Supraleiter soll dabei ein großes Aspektverhältnis aufweisen. Aus diesem Grunde werden Probleme bei einer dünnen Isolation mittels eines Lackierverfahrens gesehen. Deshalb soll der bekannte Leiter ein Trägerband mit Aussparungen enthalten, in die einzelne bandförmige Hoch-T_{c}-Supraleiterbänder eingebracht und dort fixiert werden. Der so gewonnene Aufbau aus Trägerband und eingelagerten Supraleiterbändern wird dann mit einer Lackschicht mit einer Schichtdicke zwischen 5 µm und 250 µm aus einem mittels UV-Licht aushärtbaren/vernetzbaren Polymer beschichtet. Ein entsprechend aufgebauter Leiter ermöglicht jedoch wegen der Verwendung des Trägerbandes nur einen verhältnismäßig kleinen Querschnitt an supraleitendem Material, so dass seine Stromtragfähigkeit dementsprechend beschränkt ist. Außerdem ist sein Aufbau verhältnismäßig aufwendig zu erstellen.

Aus der DE 198 20 489 A1 geht ferner ein Verfahren zur Herstellung eines langgestreckten Supraleiters insbesondere in Bandform unter Verwendung von in normalleitendes Matrixmaterial eingebetteten HTS-Material hervor. Sein Leiteraufbau kann dabei unter anderem auch mit einer Umhüllung aus einem nicht-metallischen, insbesondere isolierenden Material versehen werden, das eine größere mechanische Festigkeit als sein normalleitendes Material aufweisen soll. Als Umhüllungsmaterial kann deshalb beispielsweise ein mit Fasern aus Bor, Graphit oder Kohlenstoff verstärkter Kunststoff gewählt werden.

Entsprechende faserverstärkte Kunststoffe lassen sich nur mit verhältnismäßig großer Schichtdicke auf einem Leiteraufbau aufbringen, wobei bei einem von der Kreisform abweichenden Leiterquerschnitt auch Probleme hinsichtlich einer gleichmäßigen Schichtdicke auftreten können. Ein diesbezügliches Beschichtungsverfahren ist in der DE-A-Schrift nicht näher ausgeführt.

Weiterhin ist aus der DE 38 26 219 A1 ein supraleitendes Kabel mit mindestens einem Leiteraufbau zu entnehmen, der aus einer dichtgepreßten Füllung aus einem pulverförmigen HTS-Material und einer rohrförmigen Umhüllung aus einem Isolationsmaterial besteht. Zur Herstellung dieses Leiters wird das pulverförmige Supraleitermaterial in die rohrförmige Umhüllung aus einem organischen, schrumpffähigen Kunststoff gefüllt. Mittels einer anschließenden Erhitzung wird aufgrund der Schrumpfung das pulverförmige Supraleitermaterial verdichtet. Vor der Erhitzung kann der Kunststoff der Umhüllung durch Bestrahlung beispielsweise mit geladenen Elementarteilchen vernetzt werden. Supraleiter mit mindestens einem in ein normalleitendes Material eingebetteten Leiterkern aus dem Supraleitermaterial sind in der DE-A-Schrift nicht angesprochen.

Aufgabe der vorliegenden Erfindung ist es, einen Supraleiter mit den eingangs genannten Merkmalen anzugeben, der auf verhältnismäßig einfache Weise und kontinuierlich mit einer verhältnismäßig dünnen Umhüllung aus einem Kunststoff-Isolationsmaterial versehen werden kann. Der Supraleiter soll dabei die Verwendung von HTS-Bandleitern mit einem typisch großen Aspektverhältnis ermöglichen.

Zur Lösung der sich auf den Supraleiter mit den eingangs genannten Merkmalen beziehenden Aufgabe soll erfindungsgemäß der Leiteraufbau mit einem Aspektverhältnis von mindestens 3, vorzugsweise mindestens 10, nachträglich allseitig mit einer Umhüllung aus dem Kunststofflack versehen sein. Dabei soll dieser Kunststofflack durch eine radikalisch oder kationisch vernetzte Mischung gebildet sein, die zumindest ein Monomer oder Oligomer sowie einen Radikale bildenden Photoinitiator bzw. einen Kationen bildenden Photoinitiator enthält.

Der Erfindung liegt die Erkenntnis zugrunde, daß ein von der Herstellung von Bändchen aus Einzelglasfasern prinzipiell bekanntes Verfahren einer Beschichtung von Oberflächen dieser Bändchen mit UV-vernetzbaren Lacken sich auf die völlig anders gearteten Oberflächen-, Geometrie- und Betriebsbedingungen von Einzelsupraleitern und Verbund-Supraleitern mit dem genannten großen Aspektverhältnis unter Verwendung der genannten Kunststofflacke übertragen läßt. Damit ergeben sich eine Reihe von Vorteilen:
a) Da jeder Leiter isoliert ist, ist bei Wicklungen eine doppelte Isolationssicherheit durch die zweilagige Umhüllung aus dem Kunststoff-Isolationsmaterial zwischen zwei Leitern gegeben.
b) Der vorisolierte Leiter kann nun ohne zusätzliche Isolationsfolie verarbeitet werden. Somit entfällt der durch das Mitwickeln einer Isolationsfolie verursachte Fertigungsaufwand.
c) Die Isolation des Leiters mit den UV-vernetzbaren Kunststofflacken geht wesentlich schneller, da diese Lacke im Durchlaufverfahren unter UV-Licht in Bruchteilen von Sekunden ausgehärtet werden. Damit wird auch eine im Hinblick auf die Gefahr einer Degradation der supraleitenden Eigenschaften unerwünschte Erwärmung des Leiters weitgehend vermieden. Eine Vorerwärmung des Leiters vor dem Isolationsprozeß entfällt ebenfalls.
d) Durch die UV-Härtung können lange Trocknungsstrecken mit mehrfachen Leiterumlenkungen entfallen, die bei herkömmlichen Lackierisolierverfahren üblich sind und die Anwendung dieser Verfahren insbesondere für HTS-Leiter unmöglich machen.
e) Die Haftung von UV-vernetzbaren Kunststofflacken auf bei Supraleitern üblichen Leiteroberflächen ist ausgezeichnet.
f) Darüber hinaus ist eine gute Benetzbarkeit der vernetzbaren Kunststofflacke mit einem für eine Imprägnierung einer Leiterwicklung erforderlichen Gießharz und eine gute Haftung des Harzes auf der Umhüllung festzustellen.
g) Die mechanische Festigkeit der UV-vernetzbaren Kunststofflacke ist sehr gut.
h) Die Oberfläche der Umhüllung ist glatt und erlaubt somit ein Gleiten von verschiedenen aufeinanderliegenden isolierten Einzelleitern gegeneinander, wie es bei einer Herstellung und Verarbeitung von Verbundleitern notwendig ist.
i) Nach einem Abkühlen auf die Betriebstemperatur von beispielsweise 77 K bleibt die Lackschicht rißfrei.
j) Die UV-vernetzbaren Kunststofflacke sind lösungsmittelfrei; aufwendige technische Einrichtungen zur Absaugung und Nachbehandlung von Lösemitteldämpfen sind somit nicht erforderlich.

Vorteilhaft wird ein Kunststofflack der Umhüllung vorgesehen, der eine radikalisch oder kationisch vernetzte Mischung zumindest aus einem Monomer oder Oligomer (gegebenenfalls auch Polymer; vgl. Lexikon "Römpp": Chemie, 10. Auflage, 1998, Seite 3010) sowie aus einem entsprechenden Photoinitiator enthält. Solche aus kommerziell vertriebenen Komponenten bestehende Gemische weisen eine gute Benetzbarkeit von bzw. Haftung an den Leiteroberflächen üblicher Supraleiter auf. Sie zeigen zudem ein gutes Tieftemperaturverhalten und sind mit geringen Schichtdicken von insbesondere unter 50 µm gleichmäßig auch auf Supraleitern aufzubringen, die eine von einer Kreisform abweichende Querschnittsform, insbesondere eine Bandform mit dem beanspruchten hohen Aspektverhältnis besitzen.

Entsprechende Umhüllungen sind außerdem für Supraleiter mit Leiterkernen aus HTS-Material besonders geeignet. Solche Supraleiter dürfen nämlich nur kurzfristig gering erwärmt werden (beispielsweise maximal auf 200°C während höchstens einer Minute), um eine Degradation ihrer supraleitenden Eigenschaften auszuschließen. Die gewählten UV-vernetzbaren Künststofflacke lassen sich vorteilhaft unter entsprechenden Verfahrensbedingungen aushärten.

Entsprechende Umhüllungen können überraschenderweise auch für bandförmige Supraleiter mit hohem Aspektverhältnis von insbesondere mindestens 3, vorzugsweise mindestens 10 vorgesehen werden, ohne daß im Bereich der Kanten oder Schmalseiten auch bei geringen Schichtdicken die Gefahr einer sogenannten Kantenflucht, d.h. einer Unterbrechung der Umhüllung im Bereich der Kanten, gegeben ist.

Selbstverständlich kann eine entsprechende Umhüllung nicht nur für einen einzigen Supraleiter, sondern auch um einen Leiteraufbau (-zusammensetzung) aus mehreren supraleitenden Teilleitern oder Leiterelementen vorgesehen werden.

Vorteilhafte Ausgestaltungen des erfindungsgemäßen Supraleiters gehen aus den von Anspruch 1 abhängigen Ansprüchen hervor.

Ein vorteilhaftes Verfahren zur Isolation eines Supraleiters ist dadurch gekennzeichnet, daß der Leiteraufbau durch ein Bad mit dem vernetzbaren, hinreichend viskosen Kunststofflack gezogen wird, gegebenenfalls die an dem Leiteraufbau dann anhaftende Lackschicht auf eine geforderte Schichtdicke reduziert wird, sowie die Lackschicht durch UV-Bestrahlung vernetzt und ausgehärtet wird. Die Anwendung dieses Verfahrens auf Supraleiter und insbesondere auf HTS-Leiter mit ihrer typischen thermischen und mechanischen Empfindlichkeit, ihrem sehr speziellen Aspektverhältnis sowie ihren einerseits glatten, andererseits mit Fremdschichten versehenen Oberflächen erfordert nämlich eine sehr spezifische, erfindungsgemäß eröffnete Verfahrenslösung. Diese erschließt gerade den bekannten HTS-Leitern ein erweitertes Anwendungsgebiet aufgrund der einfacheren Verwendbarkeit bereits vorisolierter Leiter.

Weiterhin sind beträchtliche Kosteneinsparungen gegeben, da der UV-vernetzte Lack im Vergleich zu einer Kapton-Folie deutlich preisgünstiger ist und ein kontinuierliches, schnelles Verfahren eine rationelle Leiterisolation ermöglicht. Besonders überraschend ist, daß die insbesondere als Einzelschicht aufgebrachte und vernetzte UV-Lackschicht auch bei Betriebstemperaturen von 77 K und darunter auf der Leiteroberfläche gut haftet und rißfrei bleibt.

Vorteilhafte Ausgestaltungen des Verfahrens gehen aus den von dem übergeordneten Verfahrensanspruch 5 abhängigen Ansprüchen hervor.

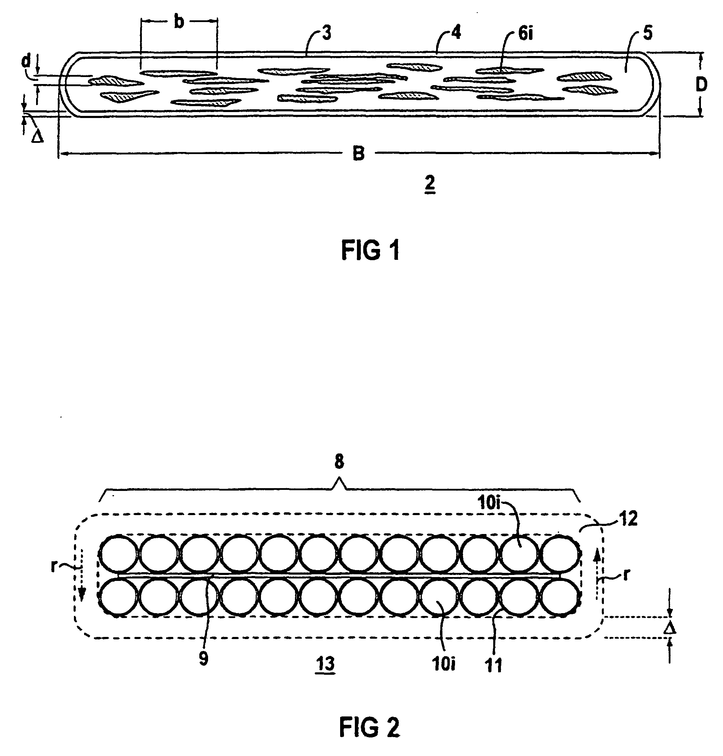

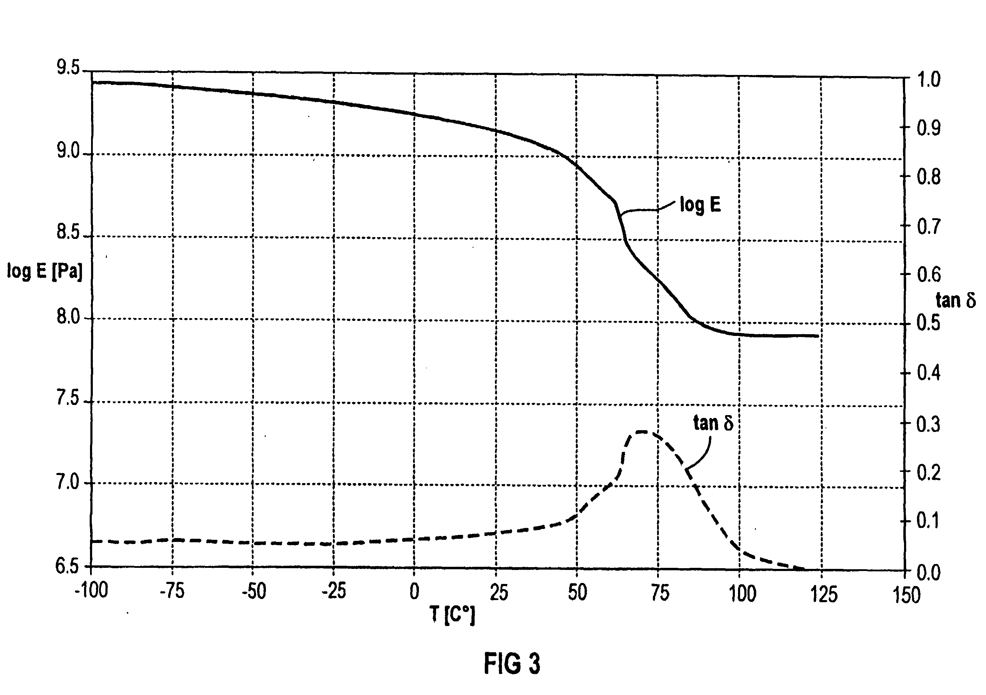

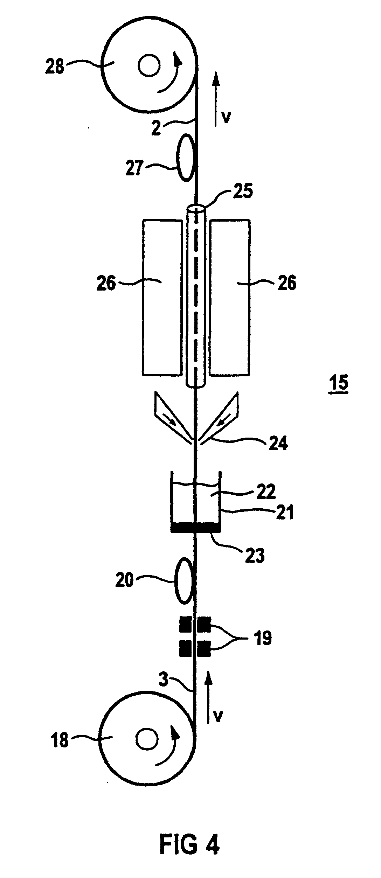

Die Erfindung wird nachfolgend anhand der Zeichnung noch weiter erläutert. Dabei zeigen jeweils schematisch
- deren Figuren 1 und 2: zwei verschiedene Ausführungsformen von erfindungsgemäßen Supraleitern,
- deren Figur 3: die thermomechanischen Eigenschaften eines geeigneten Lackes zur Isolation
und
- deren Figur 4: eine Anlage zur erfindungsgemäßen Isolation eines entsprechenden Supraleiters.

In den Figuren sind sich entsprechende Teile jeweils mit denselben Bezugszeichen versehen.

Der in Figur als Querschnitt gezeigte, allgemein mit 2 bezeichnete isolierte Supraleiter setzt sich im wesentlichen aus zwei Teilen zusammen, nämlich aus einem zentralen Leiteraufbau 3, der zumindest weitgehend metallisch ist, und einer darum angeordneten, allseitigen Umhüllung 4 aus einem besonderen Isolationsmaterial. Bei dem metallischen Leiteraufbau 3 handelt es sich um eine bekannte Ausführungsform eines Supraleiteraufbaus, der im wesentlichen eine Matrix 5 aus mindestens einem normalleitenden Material aufweist, in welche wenigstens ein supraleitender Leiterkern 6i oder ein entsprechendes Filament eingebettet ist. Der mindestens eine supraleitende Leiterkern kann dabei metalloxidisches Hoch-T_{c}-Supraleitermaterial (HTS-Material) wie z.B. ein Y- oder Bi-Cuprat enthalten. Die Querschnittsform des Leiteraufbaus 3 ist bandförmig. Für das in Figur 1 gezeigte Ausführungsbeispiel sei als Leiteraufbau 3 ein bandförmiger Multifilament-Supraleiter mit Leiterkernen 6i aus dem HTS-Material (Bi,Pb)₂Sr₂Ca₂Cu₃Oₓ in einer Ag-Matrix 5 angenommen. Das Matrixmaterial kann auch eine Ag-Legierung, ein sonstiges Ag-haltiges Material oder gegebenenfalls auch ein anderes bekanntes Material sein. Ein entsprechender Leiteraufbau und ein Verfahren zu dessen Herstellung sind z.B. in der DE 198 20 489 A1 beschrieben. Dieser Leiteraufbau hat beispielsweise eine Banddicke D zwischen 200 und 350 µm, eine Bandbreite B zwischen 3,5 und 4,5 mm, und enthält beispielsweise 19 Leiterkerne 6i aus dem fertigen HTS-Material mit einer mittleren Leiterkerndicke d zwischen 5 und 15 µm und einer mittleren Leiterkernbreite b zwischen 150 µm und 180 µm. Er weist somit das für einen derartigen bandförmigen HTS-Leiteraufbau typische Aspektverhältnis von mindestens 3, vorzugsweise mindestens 10 auf.

Der zentrale Leiteraufbau kann - abweichend von der in Figur 1 gezeigten Ausführungsform des Leiteraufbaus 3 - auch aus mehreren Teilleitern oder Leiterelementen zusammengesetzt sein. Figur 2 zeigt einen entsprechenden, allgemein mit 8 bezeichneten Leiteraufbau, wie er z.B. der DE 196 20 824 C1 zu entnehmen ist. Der Leiteraufbau 8 ist hier aus mehreren um ein bandförmiges Trägerelement 9 angeordneten Leiterelementen 10i zusammengesetzt. Bei den Leiterelementen 10i kann es sich um Ein- oder Mehrkernleiter mit HTS-Material in normalleitendem Matrixmaterial handeln. Die Leiterelemente können gegebenenfalls eine Außenschicht 11 aus einem von dem Matrixmaterial z.B. aus Ag abweichenden Material wie z.B. aus einer AgMg0,23-Legierung aufweisen. Sie sollen gemäß dem gewählten Ausführungsbeispiel um das Trägerelement 9 herum geröbelt sein. Der Drehsinn bei der Röbelung ist durch mit r bezeichnete Pfeile angedeutet. Um den so gewonnenen, bandförmigen Röbelleiteraufbau ist eine isolierende Umhüllung 12 angebracht. Der somit isolierte Supraleiter ist in der Figur mit 13 bezeichnet.

Der Leiteraufbau 3 oder 8 soll erfindungsgemäß nachträglich, d.h. nach zumindest weitgehender Fertigstellung dieses Aufbaus, mit der Umhüllung 4 bzw. 12 aus einem UV-vernetzbaren und -aushärtbaren Kunststofflack versehen werden. Die Dicke Δ dieser Umhüllung ist abhängig vom jeweiligen Anwendungsfall. Sie kann insbesondere unter 50 µm, vorzugsweise zwischen 10 und 30 µm liegen, beispielsweise 15 µm betragen. Das erfindungsgemäße Umhüllen des Leiteraufbaus gemäß Figur 1 bzw. 2 erfolgt durch kontinuierliche Belackung bei Raumtemperatur mit einem UV-vernetzbaren, -aushärtbaren Kunststofflack nach an sich bekannten Lackauftragsverfahren (vgl. z.B. das Buch Lacke und Lösemittel" von U. Biethan u.a., Verlag Chemie, Weinheim/DE, 1979, Seiten 97 bis 104). Zur Erzeugung einer Schicht aus dem Lack sind beispielsweise geeignet:
- Auftragen mittels Rollen ggf. mit wählbarer Oberflächenstruktur wie z.B. Rillen,
- Sprühen,
- vollständiges Eintauchen und anschließendes seitliches Abblasen des überschüssigen Reaktionsharzes.

Die für den jeweiligen Auftragsprozess erforderliche und optimale Viskosität des Lackes kann über geschickte Auswahl der Ausgangskomponenten und/oder durch Anpassung der Verarbeitungstemperatur eingestellt werden. Vorteilhaft erfolgt die Belackung unter Ausschluß von UV-Licht oder Tageslicht, um ein ungewolltes Angelieren des Lackmaterials zu vermeiden. Unmittelbar anschließend an die Belackung wird die aufgebrachte Lackschicht durch Bestrahlung mit UV-Licht ausgehärtet. Die prinzipiellen Einzelheiten einer solchen UV-Härtung sind z.B. der Literaturstelle "Journal of Coating Technology", Vol. 59, No. 751, August 1987, Seiten 97 bis 106 zu entnehmen.

Grundsätzlich handelt es sich bei UV-vernetzenden Lacken um flüssige, lösungsmittelfreie Zusammensetzungen, die unter Ausschluß von UV-Licht über Monate lagerstabil sind, d.h., keinen Viskositätsanstieg zeigen. Für die erfindungsgemäße Umhüllung sind besondere UV-vernetzende Mischungen geeignet, die nach kationischem Mechanismus als auch im Rahmen einer radikalischen Polymerisation reagieren.

Kationisch polymerisierbare Lacke enthalten Monomere oder Oligomere, die im Rahmen einer kationischen Polymerisation gehärtet werden können, sowie mindestens einen Photoinitiator, der bei Bestrahlung mit UV-Licht Kationen bildet. Derartige Monomere und Oligomere sind beispielsweise aus der EP 0 126 712 B1 bekannt. Vorzugsweise sind dies epoxy- oder vinyletherfunktionelle Verbindungen.

Geeignete epoxyfunktionelle Verbindungen sind insbesondere epoxidierte Terpene oder α-Alkene, cycloaliphatische Epoxidharze, Glycidylether auf Basis von Bisphenol-A oder Bisphenol-F sowie Epoxyalkohole. Besonders bevorzugt sind cycloaliphatische Epoxidharze.

Als vinyletherfunktionelle Verbindungen kommen grundsätzlich alle vinyletherfunktionalisierten Hydroxylverbindungen in Betracht. Geeignet sind insbesondere Cyclohexandimethyloldivinylether, Triethylenglycoldivinylether, Butandioldivinylether, Bis(4-vinyloxybutyl)-isophthalat, Bis(4-vinyloxybutyl)-succinat, Bis (4-vinyloxymethyl-cyclohexylmethyl)-glutarat und Hydroxybutylmonovinylether oder vinyletherfunktionalisierte Hydroxypolyurethane mit aliphatischer oder aromatischer Grundstruktur. Bevorzugt sind Vinylether mit zwei oder mehr Vinylethergruppen pro Molekül. Zusätzlich können hydroxylgruppenhaltige Verbindungen wie Polyalkylenpolyole, Polyoxyalkylenpolyole oder cycloaliphatische Hydroxylverbindungen zugesetzt werden. Der Einsatz hydroxylgruppenhaltiger Verbindungen ist vorteilhaft, um die Reaktionsgeschwindigkeit zu erhöhen, sowie zur gezielten Einstellung der mechanischen Eigenschaften (Elastifizierung). Weiterhin ist es möglich, Mischungen aus oben genannten Verbindungen einzusetzen sowie Moleküle, die mehr als eine der genannten funktionellen Gruppen enthalten.

Geeignete Photoinitiatoren sind dem Fachmann bekannt; insbesondere kommen Triarylsulfoniumsalze mit nichtnucleophilen Anionen wie Hexafluoroantimonat oder Hexafluorophosphat in Frage.

Im Rahmen einer radikalischen Polymerisation härtende Kunststofflacke enthalten Monomere oder Oligomere mit einer oder mehreren Doppelbindungen, wie sie beispielsweise bei (meth)acrylatfunktionellen Harzen vorliegen, sowie mindestens einen Photoinitiator, der bei UV-Bestrahlung Radikale bildet. Geeignete Monomere oder Oligomere sind hierbei (meth)acrylierte Epoxidharze, (meth)acrylierte Polyether, (meth)acrylierte Polyurethane sowie (Meth)acrylsäureester mehrfachfunktioneller Alkohole. Zur Erhöhung der Härtungsgeschwindigkeit und zur Erniedrigung der Viskosität dieser teilweise hochviskosen bis festen Harze können mono- und polyfunktionelle reaktive Verdünner eingesetzt werden, wie sie beispielsweise in der Literaturstelle "EuroCoat", Vol. 3, 1991, Seiten 90 bis 103 beschrieben sind.

Geeignete Photoinitiatoren, aus denen unter UV-Strahlung erforderliche Startradikale erzeugt werden, sind ebenfalls an sich bekannt (vgl. z.B. "Lehrbuch der Lacke und Beschichtungen" von H. Kittel, Band 2, S. Hirzel Verlag, Stuttgart/DE 1998, Seiten 405 bis 433).

Als Photoinitiator können prinzipiell Verbindungen wie Benzoin, Benzoinether, Benzil, Benzilketale, Acetophenone, Acylphosphinoxide, Benzophenone, Thioxanthone und Campherchinon verwendet werden. Ebenfalls können Mischungen dieser Photoinitiatoren eingesetzt werden.

Durch die Wahl der Ausgangskomponenten können Verarbeitungsund Formstoffeigenschaften gezielt eingestellt werden. So läßt sich in einfacher Weise die Viskosität bzw. das Fließverhalten dem gewählten Schichterzeugungsprozeß anpassen. Ebenfalls können durch gezielte Auswahl der molekularen Struktur, der Molmasse, Funktionalität (Anzahl der reagierenden Gruppen je Molekül) die Formstoffeigenschaften der gehärteten Schicht wie Flexibilität und Glasübergangstemperatur eingestellt werden.

Sind aus verfahrenstechnischen Gründen auf der Oberfläche basische Bestandteile wie z.B. Metalloxide vorhanden, so werden bevorzugt nach radikalischem Mechanismus härtende (Meth)Acrylate eingesetzt. Durch Zugabe von an sich bekannten Additiven lassen sich die Verarbeitungs-, Härtungs- und Endeigenschaften modifizieren. Rheologische Additive wie beispielsweise pyrogene Kieselsäure verändern das Fließverhalten. Sensibilisatoren und Photoaktivatoren beeinflussen die Reaktivität und spektrale Empfindlichkeit. Oberflächenaktive Zusätze modifizieren die Oberflächenspannung und verbessern das Benetzungs- und Entgasungsverhalten, die Haftfestigkeit, aber auch die Glätte und Gleiteigenschaften der Lackoberfläche. Weiterhin können Farbstoffe, Farbpigmente oder Fluoreszenzindikatoren zugegeben werden, die den Härtungsmechanismus nicht wesentlich beeinflussen. Diese ermöglichen eine bessere visuelle Erkennung der Isolationsschicht und damit von Lakkierfehlern.

Der Härtungsprozess erfolgt unmittelbar anschließend an den Schichterzeugungsprozeß. Vorteilhaft werden gleichzeitig beide Seiten des bandförmigen Leiters mit UV-Licht bestrahlt. Hierfür können zwei Flächenstrahler gegenübergestellt und die Breitseiten bestrahlt werden. Vorteilhaft ist der Einsatz fokussierender Reflektoren. In einer bekannten Ausführung ist der Reflektor als Ellipse ausgebildet. Der längliche Strahler befindet sich im ersten Brennpunkt, während das bandfömrige Gut im zweiten Brennpunkt verläuft. Weiterhin vorteilhaft ist es, die Reflektoren so auszubilden, daß sie zwar UV-Licht, nicht aber auftreffendes Infrarotlicht absorbieren. Auf diese Weise wird die thermische Belastung der zu härtenden Lackschicht und des Leiters minimiert. Die Temperatur während der Härtung liegt unter 200°C, bevorzugt unter 100°C.

Ein konkretes Ausführungsbeispiel einer für eine erfindungsgemäße Umhüllung geeigneten Mischung aus kommerziell erhältlichen Ausgangskomponenten geht aus der nachfolgenden Auflistung hervor:

| Zusammensetzung (in Masseteilen) | |
|---|---|
| Glycerinpropoxytriacrylat | 80 |
| Isobornylacrylat | 20 |
| 2-Methyl-1-[methyl-thiophenyl]-2-morpholinopropanon-1 | 2 |
| Ethyl-4-dimethylaminobenzoat | 3 |
| Fluorad FC 430 (Additiv der Firma "3M") | 0,2 |

| Eigenschaften: | |
|---|---|
| Viskosität bei 25°C | 49 mPa s |
| Oberflächenspannung | 24,1 dyn/cm |
| Glasübergangstemperatur | 70°C |

Die thermomechanischen Eigenschaften des entsprechenden Kunststofflackes sind dem Diagramm der Figur 3 zu entnehmen.

In dem Diagramm sind in Ordinatenrichtung der Logarithmus des Elastizitätsmoduls E (durchgezogene Linie) in Pa bzw. der dielektrische Verlustfaktor tan δ (punktierte Linie) und in Abszissenrichtung die Temperatur T in °C aufgetragen. Aus dem Diagramm gehen die Glasübergangstemperatur T_{G} von etwa 70°C und der Maximalwert tan δₘₐₓ des Verlustfaktors von etwa 0,28 deutlich hervor.

Figur 4 zeigt den schematischen Aufbau einer Isolationsanlage zur Belackung von HTS-Bandleitern mit einem UV-vernetzenden Lack. Diese allgemein mit 15 bezeichnete Anlage weist in vertikaler Bandführungsrichtung v gesehen hintereinander (übereinander) die folgenden Teile auf, nämlich
eine Abwicklungvorrichtung (sogenannter "Abwickler") 18, von der ein zu belackender bandförmiger HTS-Leiteraufbau 3 abgewickelt wird,
eine Filzbremse 19,
einen Gleitschuh 20 aus PTFE zur Leiterführung,
einen Lackbehälter 21 zur Aufnahme des Kunststofflackbades 22 mit einem Silikongummiboden 23 mit Dichtlippe an seiner unteren Seite,
eine N₂-Schutzgasspülvorrichtung (sogenannte "N₂-Dusche") 24 zur Vermeidung von Oxidationen,
ein Quarzglasrohr 25 mit Schutzgasfüllung zum Hindurchführen des belackten Leiteraufbaus,
UV-Lampen 26 um das Glasrohr 25 zur Bestrahlung des Leiteraufbaus,
einen weiteren Gleitschuh 27 aus PTFE zur Leiterführung
   und
eine kraftgesteuerte Aufwickelvorrichtung (sogenannter "Aufwickler") 28 zur Aufnahme des mit der Umhüllung aus dem vernetzten, ausgehärteten Kunststofflack versehenen Bandleiters 2.

Zur Herstellung der erfindungsgemäßen Umhüllung wird also der HTS-Bandleiteraufbau 3 von dem mit der Filzbremse 19 gebremsten Abwickler 18 abgezogen und nach dem Durchlaufen der Belackungsanlage 21 bis 26 mit dem elektrischen Aufwickler 28 wieder auf eine Vorratsspule gespult. Durch die zwei Gleitschuhe 20, 27 aus PTFE in der Leiterstrecke wird erreicht, daß sich die Veränderung des Abspul- bzw. Aufspuldurchmessers nicht auf die Leiterposition in der Belackungsstrecke auswirkt.

Der eigentliche Lackauftrag erfolgt in dem Lackbehälter 21 bei Raumtemperatur, dessen Boden 23 aus dem geschlitzten Silikongummi besteht. Der Bandleiteraufbau 3 wird durch diesen Gummiboden gezogen, wobei eine Dichtlippe das Austreten des Lacks nach unten verhindert. Der belackte Leiter wird dann oberhalb des Lackbehälters durch zwei Düsen der Spülvorrichtung 24 mit gasförmigem Stickstoff angeblasen, um so die an dem Leiteraufbau 3 anhaftende Lackschicht abzudünnen. Der überschüssige Lack läuft dabei zurück in den Lackbehälter 21. Die UV-Vernetzung bzw. Aushärtung des Lacks erfolgt durch zwei UV-Lampen 26, die den in dem Glasrohr 25 geführten und mit UV-vernetzendem Lack benetzten HTS-Bandleiteraufbau anstrahlen. Die Atmosphäre in dem Glasrohr sollte zweckmäßig durch ein Schutzgas wie Stickstoff oder Argon gebildet sein, da eine UV-Härtung eines Acrylat-basierten Lackes unter sauerstoffhaltiger Atmosphäre im allgemeinen nur bei verhältnismäßig hohen UV-Leistungsdichten klebfrei möglich ist.

Neben der vorstehend angedeuteten Abdünnung der Lackschicht durch Anblasen ist es als besonders vorteilhaft anzusehen, den Supraleiter durch ein Abstreifwerkzeug mit angepaßter Geometrie eines Schlitzes zu führen. Günstig für diesen Fall ist eine Viskosität des Lackes zwischen 1 und 10 Pas bei Verarbeitungstemperatur. Ein weiterer Vorteil ist es, daß bei diesem Prozeß eine Selbstjustage des Leiters im Werkzeug erfolgt, ebenso wie eine vollständige und gleichmäßige Umhüllung auch der Kanten. Die Leiterführung durch das Werkzeug kann dabei sowohl horizontal als auch vertikal erfolgen.

Die in Figur 4 dargestellte Anlage kann dahingehend erweitert werden, daß mit ihr (auch unter Anwendung anderer Lackauftragungsverfahren) hintereinander zwei oder mehr Belackungsvorgänge ausgeführt werden. Damit sind größere Schichtdicken zu erreichen, oder man kann Doppel- oder Mehrfachschichten aus verschiedenen Kunststofflacken erzeugen.

## Patentansprüche

1. Bandförmiger Supraleiter (2, 13) mit einem Leiteraufbau (3, 8), der mindestens einen in normalleitendes Material eingebetteten Leiterkern (6i) aus einem aus oxidischem Hoch-T_{c}-Supraleitermaterial enthält und ein großes Aspektverhältnis aufweist, sowie mit einer Isolation aus einem UV-vernetzten Kunststofflack mit einer Schichtdicke (Δ) von unter 50 µm, **dadurch gekennzeichnet, dass** der Leiteraufbau (3, 8) mit einem Aspektverhältnis von mindestens 3, vorzugsweise mindestens 10, nachträglich allseitig mit einer Umhüllung (4) aus dem Kunststofflack versehen ist, wobei
a) der Kunststofflack durch eine radikalisch vernetzte Mischung gebildet ist, die zumindest ein Monomer oder Oligomer und einen Radikale bildenden Photoinitiator enthält,
oder
b) der Kunststofflack durch eine kationisch vernetzte Mischung gebildet ist, die zumindest ein Monomer oder Oligomer sowie einen Kationen bildenden Photoinitiator enthält.

2. Supraleiter nach Anspruch 1, **dadurch gekennzeichnet, dass** die radikalisch vernetzte Mischung ein monomeres und/oder polymeres Acrylat oder Methacrylat enthält.

3. Supraleiter nach Anspruch 1, **dadurch gekennzeichnet, dass** die kationisch vernetzte Mischung ein Epoxid oder einen Vinylether enthält.

4. Supraleiter nach einem der vorangehenden Ansprüche, **gekennzeichnet durch** einen Leiteraufbau (8) aus mehreren supraleitenden Leiterelementen (10i), der mit der Umhüllung (12) versehen ist.

5. Verfahren zur Isolation eines bandförmigen Supraleiters nach einem der vorangehenden Ansprüche, **dadurch gekennzeichnet, dass** der Leiteraufbau (3, 8) durch ein Bad (22) mit dem vernetzbaren, hinreichend viskosen Kunststofflack gezogen wird, gegebenenfalls die an dem Leiteraufbau (3, 8) dann anhaftende, noch viskose Lackschicht auf eine geforderte Schichtdicke (Δ) reduziert wird, sowie die Lackschicht durch UV-Bestrahlung vernetzt und ausgehärtet wird.

6. Verfahren nach Anspruch 5, **dadurch gekennzeichnet, dass** die an dem Leiteraufbau (3, 8) anhaftende Lackschicht durch Anblasen mit Stickstoff auf die geforderte Schichtdicke (Δ) abgedünnt wird.

7. Verfahren nach Anspruch 5, **dadurch gekennzeichnet, dass** die an dem Leiteraufbau (3, 8) anhaftende Lackschicht durch Abstreifen in einem entsprechenden Abstreifwerkzeug auf die geforderte Schichtdicke (Δ) abgedünnt wird.

8. Verfahren nach einem der Ansprüche 5 bis 7, **dadurch gekennzeichnet, dass** die Vernetzung und Aushärtung des Kunststofflackes in einer Schutzgasatmosphäre, insbesondere unter Stickstoff oder Argon, vorgenommen wird.

9. Verfahren nach einem der Ansprüche 5 bis 8, **dadurch gekennzeichnet, dass** der Leiteraufbau (3, 8) bei Raumtemperatur belackt wird.

10. Verfahren nach einem der Ansprüche 5 bis 9, **dadurch gekennzeichnet, dass** die Vernetzung bzw. Aushärtung bei einer Temperatur von unter 200°C vorgenommen wird.

## Claims

1. Superconductor (2, 13) in strip form with a conductor construction (3, 8) which includes at least one conductor core (6i) of an oxide high-T_{c} superconductor material embedded in material of normal conductivity and has a large aspect ratio, and also with an insulation of a UV-crosslinked polymer coating with a layer thickness (A) of less than 50 µm, **characterized in that** the conductor construction (3, 8) with an aspect ratio of at least 3, preferably at least 10, is subsequently provided on all sides with a sheath (4) comprising the polymer coating,
a) the polymer coating being formed by a free-radically crosslinked mixture which includes at least one monomer or oligomer and a free-radical-forming photoinitiator,
or
b) the polymer coating being formed by a cationically crosslinked mixture which includes at least one monomer or oligomer and a cation-forming photoinitiator.

2. Superconductor according to Claim 1, **characterized in that** the radically crosslinked mixture contains a monomeric and/or polymeric acrylate or methacrylate.

3. Superconductor according to Claim 1, **characterized in that** the cationically crosslinked mixture contains an epoxide or a vinyl ether.

4. Superconductor according to one of the preceding claims, **characterized by** a conductor construction (8) comprising a number of superconducting conductor elements (10i) which is provided with the sheath (12).

5. Method for insulating a superconductor in strip form according to one of the preceding claims, **characterized in that** the conductor construction (3, 8) is drawn through a bath (22) comprising the crosslinkable, sufficiently viscous polymer coating, any still viscous coating film then adhering to the conductor construction (3, 8) is reduced to a required coating thickness (Δ), and the coating film is crosslinked and cured by UV irradiation.

6. Method according to Claim 5, **characterized in that** the coating film adhering to the conductor construction (3, 8) is thinned to the required thickness (Δ) by blowing with nitrogen.

7. Method according to Claim 5, **characterized in that** the coating film adhering to the conductor construction (3, 8) is thinned to the required thickness (Δ) by stripping in an appropriate stripping tool.

8. Method according to one of Claims 5 to 7, **characterized in that** the crosslinking and curing of the polymer coating is performed in an inert gas atmosphere, in particular under nitrogen or argon.

9. Method according to one of Claims 5 to 8, **characterized in that** the conductor construction (3, 8) is coated at room temperature.

10. Method according to one of Claims 5 to 9, **characterized in that** the crosslinking or curing is performed at a temperature of below 200°C.

## Revendications

1. Supraconducteur (2, 13) sous forme de bande ayant une structure (3, 8) conductrice, qui comporte, incorporé dans un matériau normalement conducteur, au moins un noyau (6i) conducteur en un matériau supraconducteur oxydé à haute T_{c} et qui a un grand rapport d'aspect, ainsi qu'un isolant en un vernis de matière plastique réticulé par les UV d'une épaisseur (Δ) de couche inférieure à 50 µm, **caractérisé en ce que** la structure (3, 8) conductrice ayant un rapport d'aspect d'au moins 3, de préférence d'au moins 10, est munie ultérieurement de tous côtés d'un enrobage (4) en le vernis de matière plastique, dans lequel
a) le vernis de matière plastique est formé d'un mélange réticulé par voie radicalaire qui comprend au moins un monomère ou un oligomère et un photoamorceur formant des radicaux,
ou
b) le vernis en matière plastique est formé par un mélange réticulé par voie cationique qui comprend au moins un monomère ou un oligomère, ainsi qu'un photoamorceur formant des cations.

2. Supraconducteur suivant la revendication 1, **caractérisé en ce que** le mélange réticulé par voie radicalaire comprend un acrylate ou un méthacrylate monomère et/ou polymère.

3. Supraconducteur suivant la revendication 1, **caractérisé en ce que** le mélange réticulé par voie cationique comprend un époxyde ou un oxyde de vinyle.

4. Supraconducteur suivant l'une des revendications précédentes, **caractérisé par** une structure (8) conductrice constituée de plusieurs éléments (10i) conducteurs supraconducteurs qui est munie d'un enrobage (12).

5. Procédé pour isoler un supraconducteur en forme de bande suivant l'une des revendications précédentes, **caractérisé en ce que** l'on fait passer la structure (3, 8) conductrice dans un bain (22) ayant le vernis de matière plastique réticulable et suffisamment visqueux, le cas échéant on réduit la couche de vernis encore visqueuse adhérant alors à la structure (3, 8) conductrice jusqu'à une épaisseur (Δ) de couche exigée et l'on réticule et durcit la couche de vernis par exposition aux UV.

6. Procédé suivant la revendication 5, **caractérisé en ce que** l'on amincit à l'épaisseur (Δ) de couche souhaitée la couche de vernis adhérant à la structure (3, 8) conductrice par insufflation d'azote.

7. Procédé suivant la revendication 5, **caractérisé en ce que** l'on amincit à l'épaisseur (Δ) de couche souhaitée la couche de vernis adhérant à la structure (3, 8) conductrice par raclage dans un outil de raclage adéquat.

8. Procédé suivant l'une des revendications 5 à 7, **caractérisé en ce que** l'on effectue la réticulation et le durcissement du vernis en matière plastique sous une atmosphère de gaz protecteur, notamment sous azote ou sous argon.

9. Procédé suivant l'une des revendications 5 à 8, **caractérisé en ce que** l'on vernit la structure (3, 8) conductrice à la température ambiante.

10. Procédé suivant l'une des revendications 5 à 9, **caractérisé en ce qu'**on effectue la réticulation ou le durcissement à une température inférieure à 200°C.
